Europäisches Patentamt

European Patent Office

Office européen des brevets

(19)

(11) Numéro de publication: **0 085 607**

**A2**

(12) ## DEMANDE DE BREVET EUROPEEN

(21) Numéro de dépôt: 83400164.6

(22) Date de dépôt: 25.01.83

(51) Int. Cl.³: **H 01 L 21/78**
**H 01 L 23/48**

(30) Priorité: 02.02.82 FR 8201651

(43) Date de publication de la demande:
10.08.83 Bulletin 83/32

(84) Etats contractants désignés:
**DE GB NL**

(71) Demandeur: **THOMSON-CSF**
**173, Boulevard Haussmann**
**F-75379 Paris Cedex 08(FR)**

(72) Inventeur: **Henry, Raymond**
**THOMSON-CSF SCPI 173, bld Haussmann**
**F-75379 Paris Cedex 08(FR)**

(72) Inventeur: **Heitzmann, Michel**
**THOMSON-CSF SCPI 173, bld Haussmann**
**F-75379 Cedex 08(FR)**

(74) Mandataire: **Wang, Pierre et al,**
**THOMSON-CSF SCPI 173, Bld Haussmann**
**F-75379 Paris Cedex 08(FR)**

(54) **Procédé collectif de fabrication de diodes hyperfréquences avec encapsulation incorporée et diodes obtenues par ce procédé.**

(57) L'invention se rapporte aux dispositifs semi-conducteurs à jonction et à leur procédé de fabrication.

L'invention a pour objet une diode fabriquée par un procédé collectif dans laquelle la jonction est limitée à sa partie active (7) et est insérée dans un diélectrique (10) servant de support qui évite l'usage d'un boîtier.

L'invention s'applique notamment à la fabrication de dispositifs semi-conducteurs à avalanche, à effet Gunn, aux diodes mélangeuses et aux diodes varicap.

FIG.7

EP 0 085 607 A2

Croydon Printing Company Ltd.

# PROCEDE COLLECTIF DE FABRICATION DE DIODES HYPERFREQUENCES AVEC ENCAPSULATION INCORPOREE ET DIODES OBTENUES PAR CE PROCEDE

La présente invention se rapporte à un procédé de réalisation de façon collective, de dispositifs ayant deux faces métallisées, par exemple des diodes. Ces dispositifs se présentent sous la forme d'éléments possédant une encapsulation incorporée et ne nécessitent pas de boîtiers. Ils sont particulièrement bien adaptées au cas des diodes à effet Gunn ou à avalanche. Le fait de pouvoir contrôler facilement les dimensions géométriques de ces diodes permet de les utiliser avantageusement dans des sources d'ondes millimétriques à l'état solide en réalisant une transformation radiale d'impédance.

Lorsque la fréquence d'utilisation de diodes de type Gunn et surtout à avalanche et de diodes Schottky, utilisées comme oscillatrice à l'émission ou mélangeuse à la réception d'ondes millimétriques, croît au-dessus de 30 GH z, la capacité et l'inductance propres des boîtiers classiques deviennent de plus en plus gênantes. On cherche donc à améliorier le boîtier, notamment au-dessus de 50 GHz. Les différentes solutions proposées ne donnent pas entièrement satisfaction. En effet, parmi l'art connu, on peut relever des réalisations qui présentent l'avantage mais aussi l'inconvénient d'être pratiquement préaccordées sur une fréquence et ne sont donc pas optimisées lorsqu'on désire disposer d'une assez large bande d'accord en fréquence.

D'autres solutions amènent un prix de revient élevé ou ne se prêtent pas à une fabrication de série. En effet, alors que la puce élémentaire peut résulter d'une découpe collective dans une rondelle, l'adjonction très délicate d'une bonne encapsulation est un processus unitaire. La présente invention se propose grâce à un procédé particulier de fabrication de remédier à ces problèmes.

L'invention a pour objet un procédé collectif de fabrication d'un dispositif semiconducteur comportant une pastille semiconductrice multicouche disposée entre deux connexions, ledit procédé comportant les étapes suivantes :

a) croissance par épitaxie à partir d'un substrat semiconducteur d'un ensemble de couches destinées à fournir la structure de ladite pastille,

b) délimitation de ladite pastille par attaque dudit ensemble pour former une cuvette annulaire de profondeur supérieure à celle de l'ensemble,

c) remplissage de ladite cuvette annulaire par un matériau diélectrique, caractérisé en ce qu'il comprend en outre les étapes suivantes :

d) attaque du substrat par sa face opposée à l'ensemble de manière à former une cuvette centrale ayant pour fond ladite pastille et pour rebord ladite face opposée et dont les parois latérales sont délimitées par le diélectrique,

e) formation desdites connexions par recouvrement métallique des deux faces de la structure complexe obtenue à l'étape précédente,

f) détachement du dispositif par découpe effectuée en dehors de la cuvette centrale.

L'invention a également pour objet un dispositif semiconducteur comprenant un support ayant une première et une.seconde face métallisée, une pastille semiconductrice incluse dans ledit support et adjacente à ladite première face, une cuvette annulaire formée autour de ladite pastille à partir de ladite première face, la profondeur de ladite cuvette annulaire étant au moins égale à l'épaisseur de ladite pastille et étant comblée par un matériau diélectrique, caractérisé en ce que ledit dispositif comprend en outre une cuvette centrale formée à partir de ladite seconde face, le fond de ladite cuvette centrale rejoignant ladite pastille et le rebord de ladite cuvette centrale étant formé par une partie de ladite seconde face.

L'invention sera mieux comprise au moyen de la description ci-après et des figures annexées parmi lesquelles :

- les figures 1 à 7 représentent les phases successives du procédé collectif selon l'invention ;

- la figure 8 est une vue de dessus d'une diode réalisée par le procédé selon l'invention ;

- la figure 9 est aussi une vue de dessus d'une diode réalisée par le procédé selon l'invention.

- les figures 10 à 12 sont des variantes de diodes réalisées par le procédé collectif,

- les figures 13 et 14 sont des étapes originales du procédé collectif.

A titre d'exemple non limitatif, on va décrire l'élaboration de diodes à avalanche au silicium par le procédé de fabrication de l'invention. Ce type de diode peut en particulier être employé dans des modules pour ondes millimétriques (pour des fréquences de fonctionnement de l'ordre de 100 GHz) du fait de la grande accessibilité de leurs composantes géométriques.

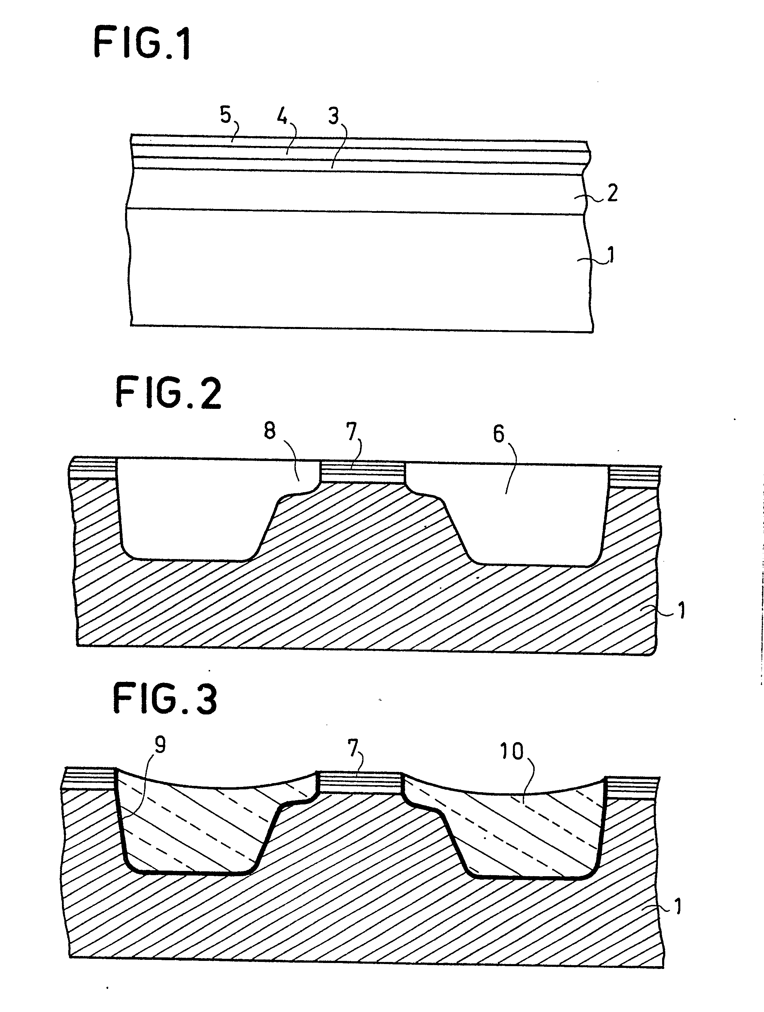

Pour réaliser la jonction, on fait croître par épitaxie sur une rondelle de silicium monocristallin de haute résistivité une succession de couches de types de conductivité différents qui formeront une structure semiconductrice. On appellera S la section de la rondelle, W son épaisseur, $\rho$ sa résistivité et $\epsilon$ sa constante diélectrique. On peut assimiler la rondelle à une résistance branchée en parallèle sur une capacité. La rondelle se comportera d'autant plus comme un diélectrique que le courant traversant la rondelle soumise à une tension électrique de pulsation $\omega$ entre ses deux faces sera beaucoup plus obtenu par l'effet capacitif que par l'effet résistif du schéma électrique équivalent à la rondelle. Ceci est réalisé si : $\rho \, \epsilon \, \omega \gg 1$. On part donc d'une rondelle de haute résistivité. Cette rondelle sera dite $\nu$ si le peu d'impuretés incluses dans le semi-conducteur est de type N, et $\pi$ si elles sont de type P. Si le résidu d'impuretés était nul, le matériau serait appelé I (intrinsèque). La figure 1 est une vue en coupe d'une partie de la rondelle. On y voit la rondelle originale 1. qui est peu ou pas dopée à l'encontre des procédés usuels de fabrication pour lesquels on partait généralement d'un substrat dopé N$^+$. L'épaisseur de cette rondelle est d'environ 100 microns pour des raisons techniques qui seront exposées plus loin. Sa résistivité est de l'ordre de 4000 $\Omega$.cm ou plus. La première couche développée sur la rondelle est la couche 2 dopée N$^+$ de résistivité 0,003 $\Omega$.cm et d'environ 5 à 10 microns d'épaisseur. Viennent ensuite une couche 3 de type N (épaisseur 0,35 micron, dopage $2.10^{17}$ atomes/cm$^3$), une couche 4 de type P (épaisseur 0,35 micron, dopage $2.10^{17}$ atomes cm$^3$), et une couche 5 de type P$^+$ (épaisseur 0,3 micron, dopage $5.10^{19}$ atomes/cm$^3$). Il s'agit donc d'une diode à avalanche à double zone de glissement.

La deuxième phase du procédé concerne la délimitation des futures diodes. Elle consiste à effectuer une attaque chimique de type Mésa progressant à partir des couches épitaxiées jusque dans le substrat 1, afin de créer des sillons 6 formant des cuvettes annulaires qui délimitent les futures diodes. Les jonctions se présenteront donc sous la forme de pastilles. Par souci de simplification, on a repéré l'ensemble des couches épitaxiées par un repère unique 7. A ce stade, la rondelle présente l'aspect illustré par la coupe de la figure 2. Le sillon entourant chaque diode peut être circulaire. Dans ce cas, on réalise pour des fréquences de fonctionnement de l'ordre de 94 GHz, des éléments dont les caractéristiques géométriques sont environ les suivantes :

- diamètre de la jonction : 30 microns
- diamètre extérieur du sillon : 400 microns
- profondeur du sillon : 30 microns.

Pour des considérations théoriques relatives à l'utilisation de ce type de diodes dans des modules pour ondes millimétriques, on a réalisé le sillon suivant un profil particulier tel que représenté par la coupe de la figure 2. Ce profil a été obtenu par une attaque chimique réalisée en deux étapes. Par exemple, avec un premier masque on a provoqué l'attaque de la rondelle jusqu'à atteindre la profondeur correspondant à l'épaulement 8, puis avec un second masque de surface plus restreinte on a repris l'attaque de la rondelle de façon à obtenir le profil représenté. Sur la figure 2, dont la coupe a été effectuée selon un diamètre du sillon 6, on remarque l'épaulement 8 dont la profondeur est à peu près égale à l'épaisseur totale des couches épitaxiées.

Dans l'étape suivante on recouvre de préférence les parois des sillons d'une mince pellicule d'arrêt 9 qui est composée d'un matériau résistant à l'agent chimique qui sera employé ultérieurement au cours d'une phase d'attaque. Par exemple, on peut utiliser du nitrure de silicium $Si_3 N_4$ ou de la silice $SiO_2$ qui résiste à un agent chimique d'attaque du silicium tel qu'un mélange d'acide nitrique et d'acide fluorhydrique. Ensuite ces sillons sont remplis par un matériau diélectrique. Il est avantageux d'effectuer ce remplissage par du verre fondu qui a d'assez bonnes propriétés diélectriques aux fréquences considérées ainsi que de bonnes propriétés mécaniques. De plus ce diélectrique doit pouvoir résister aux températures élevées que l'on rencontre dans les diodes à avalanche (jusqu'à 300° C). On remarque également que le diamètre extérieur du sillon est de l'ordre de grandeur de la demi-longueur d'onde, dans le diélectrique considéré, des signaux électriques mis en oeuvre dans ce type de dispositif. La quantité de verre est dosée de façon que sa surface soit plane ou légèrement concave. La figure 3 représente une fraction de la rondelle 1 en coupe. On remarque la couche d'arrêt 9 recouvrant les parois du sillon, lequel a été rempli de verre fondu 10. Dans cet exemple d'application du procédé la quantité du verre a été dosée de façon à disposer d'une légère concavité en surface. Ceci permet de pouvoir souder la diode à l'envers sans avoir besoin d'une forte épaisseur de métallisation et de soudure.Cette soudure à l'envers est une nécessité pour les diodes à avalanche.

Il entre dans le cadre de l'invention d'utiliser d'autres diélectriques que le verre, par exemple des matériaux polymérisables.

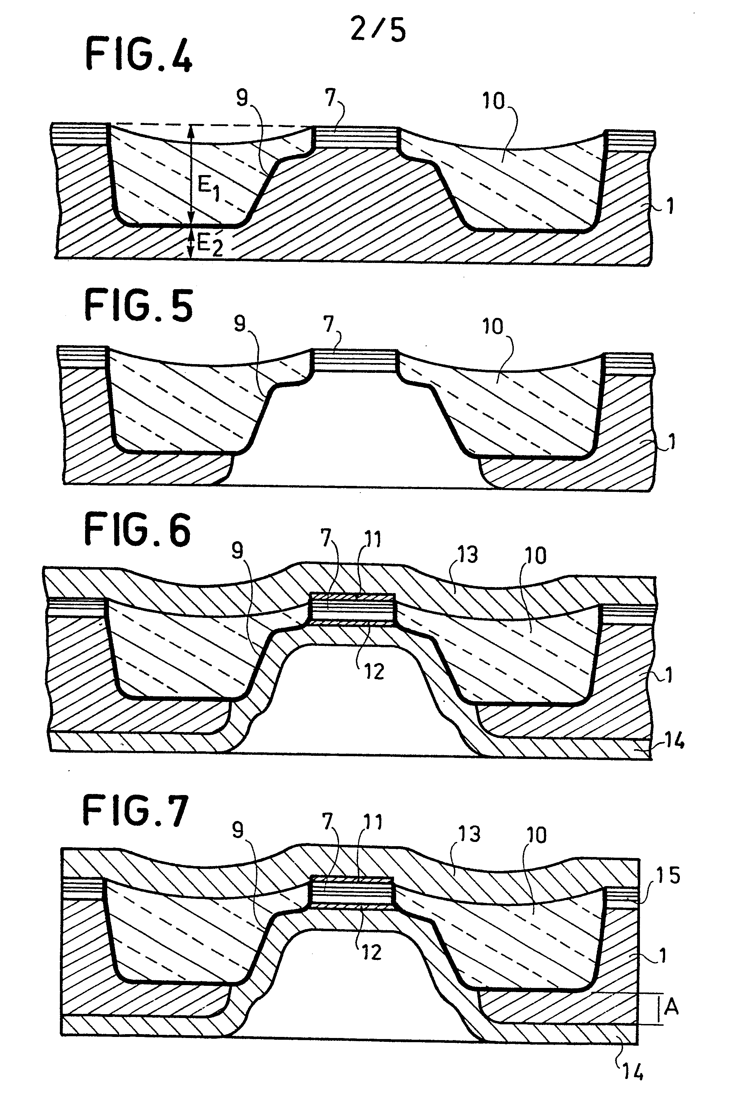

L'épaisseur de la rondelle a été volontairement choisie supérieure à 100 microns afin de pouvoir réaliser correctement des sillons dont la profondeur maximale est environ 30 microns et de les remplir de diélectrique. Le choix d'une rondelle originale de plus faible épaisseur pourrait poser des problèmes dus aux contraintes mécaniques. L'étape représentée à la figure 4 consiste à roder si nécessaire la rondelle côté intrinsèque afin de l'amener à l'épaisseur désirée, et de minimiser les pertes que pourrait introduire une épaisseur trop forte de silicium malgré sa haute résistivité. On peut même envisager de continuer le rodage jusqu'à entamer le verre. Dans le cas représenté par la figure 4, on a choisi d'avoir $E_2$ beaucoup plus petit que $E_1$.

On procède ensuite à l'attaque chimique des zones de la rondelle internes aux sillons annulaires en utilisant une technique de masquage. Cette attaque est conduite jusqu'à la première couche épitaxiée adjacente au substrat 1, en éliminant même une partie de cette zone $N^+$. Le contrôle de l'épaisseur de la jonction peut se faire par un test de transparence à l'infrarouge. Cette attaque s'effectue de préférence en plasma réactif à cause de l'anisotropie possible de l'attaque. La figure 5 montre le résultat obtenu à l'issu de cette attaque. Le masquage utilisé a permis de conserver sous le sillon une certaine partie du substrat et de former une cuvette centrale.

Cette cuvette centrale a donc pour fond une couche de la pastille semiconductrice et pour rebord une partie de la face du substrat d'où l'on a conduit
l'attaque. La couche d'arrêt 9 a évité l'attaque possible du verre par l'agent
chimique. On obtient ainsi une jonction limitée à sa partie active et insérée
dans un support aux dimensions contrôlées.

L'étape représentée par la figure 6 consiste à métalliser les faces
d'accès de la jonction afin de réaliser des connexions. Il est avantageux
d'étendre les métallisations sur chaque face de la rondelle en opérant par
exemple, par pulvérisation cathodique. Une méthode avantageuse consiste à
déposer d'abord sur chaque face de la jonction une couche (11, 12) de platine
et de former du siliciure de platine par traitement thermique à une
température d'environ 400°C, puis des dépôts successifs sur tout ou partie
des faces de la rondelle de titane, de platine et d'or.

L'ensemble des dépôts titane-platine-or est représenté sur la figure 6
par les couches 13 et 14. Dans le cas de l'utilisation en régime continu d'une
telle diode à avalanche la partie de la jonction qui s'échauffe le plus est la
partie supérieure, si l'on considère la figure 6, c'est-à-dire celle qui est
proche des couches de métallisations 11 et 13. Il se pose alors le problème
de l'évacuation de la chaleur dégagée par la jonction en fonctionnement. La
réalisation de la diode selon l'invention a l'avantage de dégager le plus
possible le côté de la jonction qui chauffe le plus de son support, surtout si
le diélectrique 10 présente sa surface libre légèrement concave. Pour une
meilleure évacuation de la chaleur, on soude généralement les diodes à
avalanche par soudure inversée c'est-à-dire sur la métallisation 13 (Ti-
Pt Au). Pour cela on prévoit pour le contact 13 une croissance électrolytique d'or qui sert d'amortisseur thermique et mécanique entre la brasure
et la diode. Dans le cas d'une soudure inversée sur diamant II A, qui est une
variété cristallographique du diamant commercialisée par la société sud-
africaine Drucker et dont la conductivité thermique est nettement supérieure à celle du cuivre, on pourra limiter l'épaisseur de la couche d'or par
exemple à 2 microns et opérer par thermocompression pour que l'évacuation
de la chaleur soit assurée au maximum par le diamant. Si la diode doit être
utilisée en régime pulsé la chaleur engendrée pendant l'utilisation de la
diode est répartie à peu près également sur chaque face de la jonction et dans ce cas il est avantageux de prévoir une couche d'or plus épaisse pour le contact 14.

L'étape représentée par la figure 7 consiste en la séparation des diodes par découpe, par exemple par attaque chimique. La figure 7 représente une diode ainsi obtenue. Elle est caractérisée par ses dimensions géométriques, par exemple son diamètre extérieur, qui sont importantes dans beaucoup d'applications. On peut profiter de l'attaque chimique mise en oeuvre pour la séparation des diodes pour éliminer une partie du cadre en matériau intrinsèque, par exemple la partie A, ou même la totalité de ce matériau. La découpe peut également contribuer à éliminer une partie du matériau diélectrique 10. On gardera de préférence la zone 15 formée de couches épitaxiées lorsqu'on désirera une soudure inversée. En effet, cette zone est située dans le même plan que la jonction et contribue lors de la soudure à disposer d'une bonne planéité du dispositif.

Le fait de laisser subsister entièrement le cadre intrinsèque comme indiqué sur la figure 7 peut introduire des pertes aux fréquences d'utilisation de sorte que le procédé décrit est surtout intéressant sur le plan du prix de revient puisque la diode obtenue de façon collective ne nécessite pas de boîtier. Ce cadre peut être assimilé à une résistance R et une capacité C branchées en parallèle sur la jonction. Dans le cas de la diode donnée en exemple d'application, on démontre cependant que le courant dans la résistance parasite R est environ 2500 fois plus faible que le courant dans la capacité C, à la fréquence de 94 GHz.

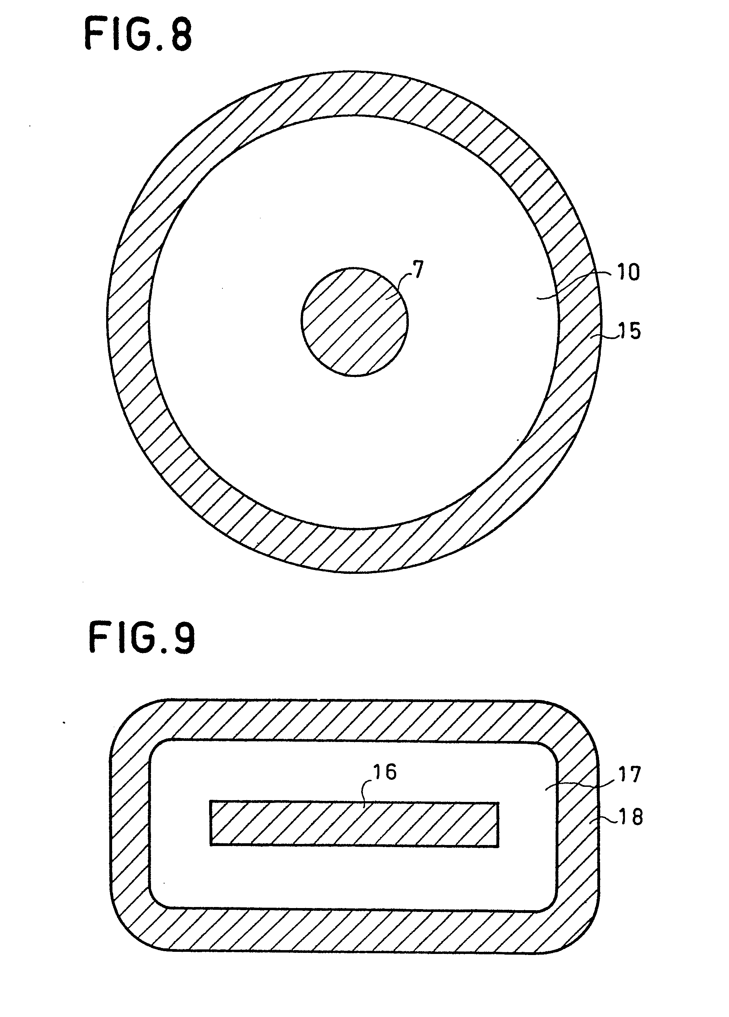

Les découpes des diodes peuvent être circulaires. Dans ce cas chaque diode se présente sous la forme d'un petit disque comme le montre la figure 8 qui est une vue de dessus d'une diode à laquelle on a ôté les métallisations 11 et 13.

On aperçoit sur cette figure la jonction 7 au centre du diélectrique 10 qui est lui-même entouré d'une couronne 15 formée des résidus des couches épitaxiées.

Il entre également dans le cadre de l'invention de donner à la jonction une forme carrée ou rectangulaire dont les surfaces en contact avec les métallisations se présentent sous la forme de rectangles allongés qui tendent à réduire la résistance thermique entre la jonction et les contacts métalliques. La figure 9 est une vue de dessus d'une telle réalisation où l'on a ôté les métallisations afin d'accéder à la jonction. On a trouvé préférable dans ce cas de donner à l'ensemble une forme également rectangulaire mais ce n'est pas une obligation. La découpe peut se faire à la scie ou éventuellement par attaque chimique de préférence très anisotrope. On distingue la jonction 16 entouré d'un diélectrique 17, qui peut être du verre comme précédemment et un cadre 18 de même nature que la jonction 16.

La forme en creux de la métallisation 14 permet néanmoins une prise de contact facile d'une connexion sur cette face de la diode par simple appui d'une tige dans la cavité d'utilisation.

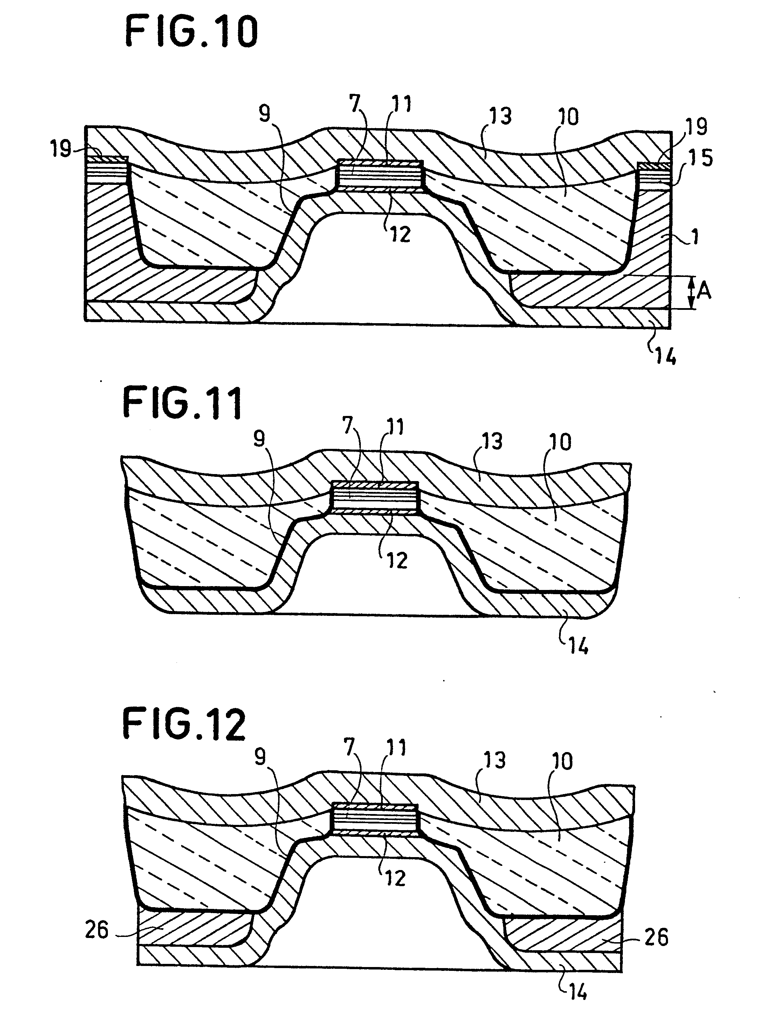

Pour limiter un éventuel courant de fuite on peut, préalablement à la métallisation, déposer localement par une technique de lift-off une couche isolante 19 par exemple sur la zone 15 ainsi que le montre le figure 10. La figure 11 montre la même diode à avalanche que celle décrite précédemment pour laquelle le substrat original 1 a été totalement éliminé, ce dernier peut alors avoir une résistivité quelconque.

Une autre découpe possible est celle qui a donné lieu au dispositif représenté à la figure 12 qui conserve une partie 26 du substrat 1. On remarque qu'il ne subsiste plus de matériau semi-conducteur reliant les électrodes. Dans ce cas, si les sillons sont suffisamment profonds, le matériau formant le substrat n'a pas besoin de posséder une très haute résistivité. Il faut au contraire qu'il ait une résistivité très basse pour ne pas introduire de pertes.

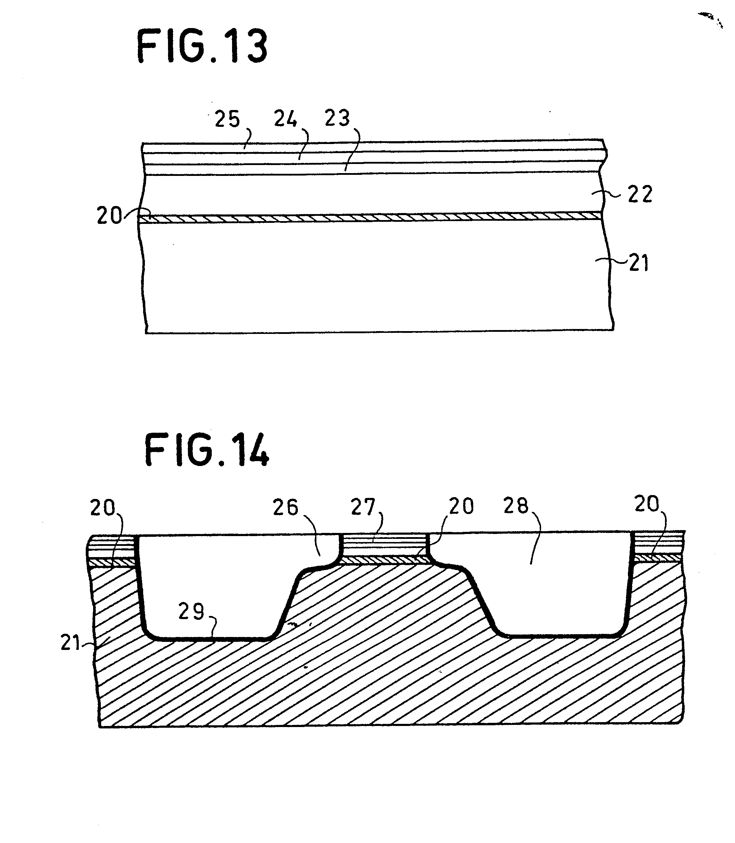

Une variante du procédé de fabrication consiste à déposer entre le substrat et les couches épitaxiées une couche d'arrêt. Dans ce cas, pour réaliser par exemple une diode à avalanche à double zone de glissement analogue à celle décrite précédemment, on peut partir d'un substrat semi-conducteur dopé $N^+$ en forme de rondelle d'un diamètre d'environ deux pouces et d'épaisseur 100 microns. Sur la figure 13, qui est une vue partielle, on remarque le substrat 22 sur lequel on a déposé une couche d'arrêt 20. Cette couche d'arrêt peut être réalisée en oxyde de silicium $SiO_2$, en nitrure de silicium $Si_3N_4$ ou par un mélange de ces deux produits. On dépose ensuite dans un réacteur d'épitaxie une couche épaisse 21 d'environ 100 microns d'épaisseur de silicium polycristallin de haute résisti-

vité ( $\rho \epsilon \omega \gg$ 1 ). Cette haute résistivité peut être obtenue par exemple en dopant légèrement le silicium avec de l'oxygène ou de l'azote. Les conditions de croissance de cette couche sont ajustées pour assurer une excellente planéité de la face supérieure de la couche 22. Cette couche 22 est ensuite amincie par rodage et/ou attaque chimique à une épaisseur d'environ 5 à 10 microns. Puis on développe par épitaxie sur la couche 22 une couche 23 dopée N, une couche 24 dopée P et une couche 25 dopée P$^+$. Les concentrations en impuretés et les épaisseurs des couches 22 à 25 sont du même ordre de grandeur que les couches correspondantes de la diode à avalanche décrite plus haut. A ce stade, le procédé de fabrication reprend alors les étapes décrites précédemment. L'avantage de cette variante est que l'attaque chimique de la face arrière, c'est-à-dire l'attaque du substrat en direction de la couche 22, s'arrête sur la couche d'arrêt 20. Cette couche d'arrêt 20 doit être éliminée partiellement pour assurer le contact avec la couche 22. Ceci se fait par attaque chimique sélective ou plutôt par usinage ionique qui assure un meilleur contrôle de l'attaque.

Dans le cas de la variante comme dans le cas décrit plus haut, le sillon peut avoir une profondeur supérieure ou égale à l'épaisseur de la structure semi-conductrice formant la diode. Si le sillon a une épaisseur supérieure à l'épaisseur de la structure, l'attaque chimique contribuant à creuser ce sillon doit être capable d'éliminer partiellement la couche d'arrêt 20 et venir mordre dans le substrat 21. Ceci est représenté à la figure 14 qui est une coupe de la rondelle en cours de fabrication, réalisée selon un diamètre du sillon. On remarque le sillon 28 comprenant un épaulement 26, la structure semi-conductrice 27 et des résidus de la couche d'arrêt 20. Une autre couche d'arrêt 29 est ensuite déposée sur les parois du sillon. Cette couche devra protéger le diélectrique qui remplira le sillon de l'attaque chimique du substrat 21 lors de l'accès à la couche 22. Si on prévoit pour le sillon une profondeur égale à l'épaisseur de la structure semi-conductrice 27, la couche 20 peut servir à arrêter l'attaque chimique nécessaire au creusement du sillon. Cette couche peut être ensuite éliminée partiellement par usinage ionique afin d'accéder à la couche 22.

L'invention s'applique aussi à toute diode que l'on désirerait monter à l'endroit. Elle s'applique également aux diodes réalisées à partir d'arséniure de gallium, notamment aux diodes à effet Gunn, aux diodes mélangeuses et éventuellement aux diodes varicap. Il fant dans ce cas employer le procédé selon l'invention en rapport avec la technologie appropriée à l'arséniure de gallium.

Le procédé selon l'invention et son résultat apportent des avantages notables à l'art connu qui sont :

- un procédé collectif de fabrication sur rondelle,
- l'inutilité d'un boîtier
- la réalisation d'une soudure inversée dans d'excellentes conditions et une bonne planéité du dispositif,
- la possibilité de donner des formes diverses à la jonction,
- l'accessibilité aux dimensions du composant et en particulier à l'anneau de diélectrique entourant la jonction ce qui permet une bonne transformation radiale d'impédance dans le cas de modules pour ondes millimétriques.. .

11

## REVENDICATIONS

1. Procédé collectif de fabrication d'un dispositif semiconducteur comportant une pastille semiconductrice multicouche (7, 27) disposée entre deux connexions, ledit procédé comportant les étapes suivantes :

a) croissance par épitaxie à partir d'un substrat semiconducteur (1) d'un ensemble de couches destinées à fournir la structure de ladite pastille,

b) délimitation de ladite pastille par attaque dudit ensemble pour former une cuvette annulaire (6, 28) de profondeur supérieure à celle de l'ensemble,

c) remplissage de ladite cuvette annulaire par un matériau diélectrique (10), caractérisé en ce qu'il comprend en outre les étapes suivantes :

d) attaque du substrat par sa face opposée à l'ensemble de manière à former une cuvette centrale ayant pour fond ladite pastille et pour rebord ladite face opposée et dont les parois latérales sont délimitées par ledit matériau diélectrique (10),

e) formation desdites connexions par recouvrement métallique des deux faces de la structure complexe obtenue à l'étape précédente,

f) détachement du dispositif par découpe effectuée en dehors de la cuvette centrale.

2. Procédé collectif de fabrication selon la revendication 1, caractérisé en ce que ledit substrat semiconducteur (1) possède une haute résistivité pour les fréquences d'utilisation des dispositifs semiconducteurs.

3. Procédé collectif de fabrication selon l'une des revendications 1 ou 2, caractérisé en ce qu'il comporte une étape d'usinage de la face du substrat opposé à ladite structure afin d'en réduire l'épaisseur.

4. Procédé collectif de fabrication selon la revendication 1, caractérisé en ce que le substrat semiconducteur est constitué d'une première couche (22) destinée à faire partie de ladite pastille et d'une seconde couche (21) de haute résistivité, ces deux couches (21, 22) étant séparées par une couche d'arrêt (20) qui est ensuite éliminée sélectivement avant la formation des connexions.

5. Procédé collectif de fabrication selon l'une quelconque des revendications 1 à 4, caractérisé en ce que les parois de ladite cuvette annulaire sont recouverts d'une couche d'arrêt (9, 29).

6.Procédé collectif de fabrication selon l'une quelconque des revendications 1 à 5, caractérisé en ce que ledit remplissage est réalisé par dépôt de verre à l'état fondu.

7. Procédé collectif de fabrication selon l'une quelconque des revendications 1 à 6, caractérisé en ce que ledit remplissage est dosé de telle façon que le matériau diélectrique présente une surface concave.

8.Procédé collectif de fabrication selon l'une des revendications 1 à 7, caractérisé en ce que ledit détachement du dispositif se fait par attaque chimique.

9. Procédé collectif de fabrication selon la revendication 8, caractérisé en ce que ladite attaque chimique enlève aussi au moins une partie dudit matériau semiconducteur entourant le matériau diélectrique (10).

10. Procédé collectif de fabrication selon l'une des revendications 1 à 9, caractérisé en ce que ledit détachement du dispositif contribue aussi à éliminer une partie du matériau diélectrique (10).

11. Dispositif semiconducteur comprenant un support ayant une première et une seconde face métallisée (13, 14), une pastille semiconductrice (7) incluse dans ledit support et adjacente à ladite première face, une cuvette annulaire (6) formée autour de ladite pastille à partir de ladite première face, la profondeur de ladite cuvette annulaire étant au moins égale à l'épaisseur de ladite pastille et étant comblée par un matériau diélectrique (10), caractérisé en ce que ledit dispositif comprend en outre une cuvette centrale formée à partir de ladite seconde face, le fond de ladite cuvette centrale rejoignant ladite pastille et le rebord de ladite cuvette centrale étant formé par une partie de ladite seconde face.

12. Dispositif semiconducteur selon la revendication 11, caractérisé en ce que ledit support comprend un anneau (15) entourant ledit matériau diélectrique (10), de même nature que ladite pastille (7) et situé dans le même plan que cette pastille.

13. Dispositif semiconducteur selon l'une des revendications 11 ou 12, caractérisé en ce que ledit support comprend un anneau résiduel dudit substrat et entourant ledit matériau diélectrique (10).

14. Dispositif semiconducteur selon l'une quelconque des revendications 11 à 13, caractérisé en ce qu'une couche isolante (19) sépare ledit anneau (15) de la face métallisée (13) correspondante.

FIG.1

FIG.2

FIG.3

FIG.4

FIG.5

FIG.6

FIG.7

FIG.8

FIG.9

# FIG.10

# FIG.11

# FIG.12

# FIG.13

25  24  23

22

20

21

# FIG.14

20   26   27   20   28   20

21   29